# EUROPEAN PATENT APPLICATION

(11) **EP 1 830 507 A2**
(43) Date of publication of application: **05.09.2007**
(21) Application number: 07004375.7
(22) Date of filing: 02.03.2007
(51) Int. Cl.: H04L 1/06, H04L 1/00

(54) **Apparatus and method for transmitting/receiving signal in a communication system using multiple input multiple output scheme**

(30) Priority: 03.03.2006 KR 20060020505
(71) Applicant: Samsung Electronics Co., Ltd., Suwon-si, Gyeonggi-Do (KR)
(72) Inventor: Jeong, Hong-Sil, c/o Samsung Elec. Co. Ltd., Suwon-si, Gyeonggi-do (KR); Choi, Seung-Hoon, c/o Samsung Elec. Co., Ltd., Suwon-si, Gyeonggi-do (KR); Kyung, Gyu-Bum, c/o Samsung Elec. Co., Ltd., Suwon-si, Gyeonggi-do (KR); Park, Dong-Seek, c/o Samsung Elec. Co., Ltd., Suwon-si, Gyeonggi-do (KR); Kim, Jae-Yoel, c/o Samsung Elec. Co., Ltd., Suwon-si, Gyeonggi-do (KR)
(74) Representative: Grünecker, Kinkeldey, Stockmair & Schwanhäusser Anwaltssozietät

(57) **Abstract**

An apparatus for transmitting a signal in a Multiple Input Multiple Output (MIMO) communication system includes determining transmission antennas to be used by a signal transmission apparatus depending on channel quality information received from a reception apparatus, encoding an input information data stream into a codeword using a coding scheme, mapping the codeword using a MIMO mapping scheme thereby generating at least one mapped symbol, modulating the mapped symbols into modulation symbols according to a modulation scheme, and performing transmission processing on the modulation symbols thereby generating transmission streams, and transmitting the transmission streams via the determined transmission antennas.

## Description

### PRIORITY

This application claims the benefit under 35 U.S.C. § 119(a) of a Korean Patent Application filed in the Korean Intellectual Property Office on March 3, 2006 and assigned Serial No. 2006-20505, the contents of which are incorporated herein by reference.

### BACKGROUND OF THE INVENTION

### 1. Field of the Invention

The present invention relates generally to an apparatus and method for transmitting/receiving signals in a communication system using a Multiple Input Multiple Output (MIMO) scheme, and in particular, to an apparatus and method for transmitting/receiving signals according to channel status in a communication system using a Per Antenna Rate Control (PARC) MIMO scheme that uses Low Density Parity Check (LDPC) codes (hereinafter LDPC-PARC MIMO communication system).

### 2. Description of the Related Art

The next generation communication system has developed into a packet service communication system for transmitting burst packet data to a plurality of terminals, and for suitability to transmit large amounts of data.

The next generation communication system considers using an LDPC code together with a turbo code as a channel code, and it is known that the LDPC code is superior in its performance gain during high-speed data transmission. The LDPC code can effectively correct errors caused by noises occurring in a transmission channel, thereby contributing to an increase in reliability of data transmission. In addition, in the next generation communication system, active research is being conducted on a MIMO scheme that can transmit large amounts of data at high speed by acquiring diversity gain. The next generation communication system using the MIMO scheme, if it can previously recognize channel status, can transmit signals using an optimal transmission scheme according to the channel status. The use of the optimal transmission scheme based on the channel status can improve signal transmission performance. The MIMO scheme includes a PARC MIMO scheme that previously recognizes channel status and transmits signals accordingly.

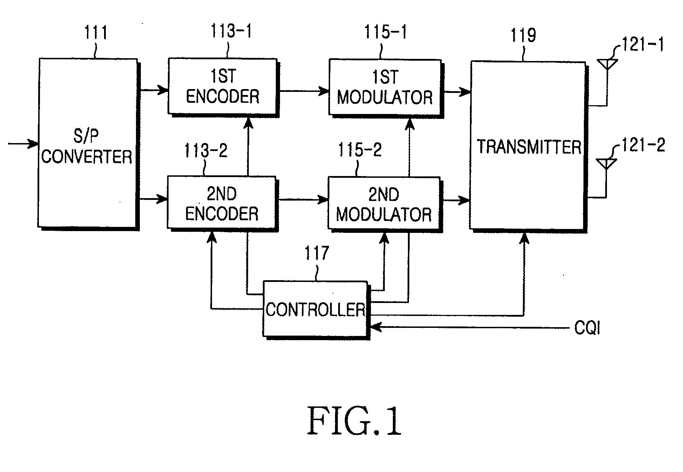

FIG. 1 illustrates a structure of a signal transmission apparatus in a conventional LDPC-PARC MIMO communication system. The signal transmission apparatus shown in FIG. 1 uses two transmission antennas Tx.ANT, by way of example.

Referring to FIG. 1, the signal transmission apparatus includes a Serial-to-Parallel (S/P) converter 111, a first (1^{ST}) encoder 113-1, a second (2^{ND}) encoder 113-2, a first (1^{ST}) modulator 115-1, a second (2^{ND}) modulator 115-2, a controller 117, a transmitter 119, a first transmission antenna 121-1 and a second transmission antenna 121-2.

If information data bits, i.e. information data stream, are received, the S/P converter 111 parallel-converts the information data stream into first and second information data streams.

The S/P converter 111 outputs the first information data stream to the first encoder 113-1, and outputs the second information data stream to the second encoder 113-2.

The first encoder 113-1, under the control of the controller 117, encodes the first information data stream into a first LDPC codeword using a preset coding scheme, and outputs the first LDPC codeword to the first modulator 115-1.

The second encoder 113-2, under the control of the controller 117, encodes the second information data stream into a second LDPC codeword using the coding scheme, and outputs the second LDPC codeword to the second modulator 115-2.
The coding scheme is an LDPC coding scheme, and an operation of controlling the first encoder 113-1 and the second encoder 113-2 by the controller 117 will be described hereinbelow.

The first modulator 115-1, under the control of the controller 117, modulates the first LDPC codeword into a first modulation symbol using a preset modulation scheme, and outputs the first modulation symbol to the transmitter 119.

The second modulator 115-2, under the control of the controller 117, modulates the second LDPC codeword into a second modulation symbol using the modulation scheme, and outputs the second modulation symbol to the transmitter 119.

An operation of controlling the first modulator 115-1 and the second modulator 115-2 by the controller 117 will be described hereinbelow.

Any scheme of Binary Phase Shift Keying (BPSK), Quadrature Phase Shift Keying (QPSK), Quadrature Amplitude Modulation (QAM), Pulse Amplitude Modulation (PAM) and Phase Shift Keying (PSK), can be used as the modulation scheme.

The transmitter 119, under the control of the controller 117, performs transmission processing on the first modulation symbol and the second modulation symbol using a preset transmission scheme, thereby generating at least one transmission stream. The transmitter 119 transmits the transmission stream via at least one of the first transmission antenna 121-1 and the second transmission antenna 121-2.
The signal transmission apparatus, as it is assumed as an LDPC-PARC MIMO communication system, receives information indicating channel status of the channel that a signal transmitted from its associated signal reception apparatus via each transmission antenna experiences. The information indicating the channel status can be, for example, Channel Quality Information (CQI). Herein, the CQI is generated based on Carrier-to-Interference and Noise Ratio (CINR), for example. The CQI indicating channel status of the channel that the signal transmitted via each transmission antenna experiences will be referred to as 'transmission antenna CQI', and the channel status of the channel that the signal transmitted via each transmission antenna experiences will be referred to as 'transmission antenna channel status', for the sake of convenience.

The controller 117 controls coding operations of the first encoder 113-1 and the second encoder 113-2 and modulation operations of the first modulator 115-1 and the second modulator 115-2 according to transmission antenna CQIs received from the signal reception apparatus.

In addition, based on the transmission antenna CQIs, the controller 117 allows the transmitter 119 to use one or both of the first transmission antenna 121-1 and the second transmission antenna 121-2.

Herein, the controller 117 detects each transmission antenna channel status using the transmission antenna CQIs. The controller 117 controls the transmitter 119 such that no signal is transmitted via a transmission antenna indicating the channel status in which the signal reception apparatus associated with the associated signal transmission apparatus cannot normally receive signals, among the detected transmission antenna channel statuses.

In this manner, the controller 117 determines transmission antennas to be used by the transmitter 119, and controls generation of transmission streams according to the number of the transmission antennas determined to be used by the transmitter 119. For example, if the controller 117 has determined to use only one of the first and second transmission antennas 121-1 and 121-2, the transmitter 119 generates one transmission stream using the first and second modulation symbols, and transmits the generated transmission stream via the determined transmission antenna.
If the controller 117 has determined to use both of the first transmission and second transmission antennas 121-1 and 121-2, the transmitter 119 generates first and second transmission streams using the first and second modulation symbols, and transmits the first and second transmission streams via the first and second transmission antennas 121-1 and 121-2, respectively.

Although not separately illustrated in FIG. 1, the signal transmission apparatus includes even a receiver for receiving the transmission antenna CQIs transmitted by the signal reception apparatus. An operation of receiving the transmission antenna CQIs by the signal transmission apparatus is well known in the art, so a detailed description thereof will be omitted herein.

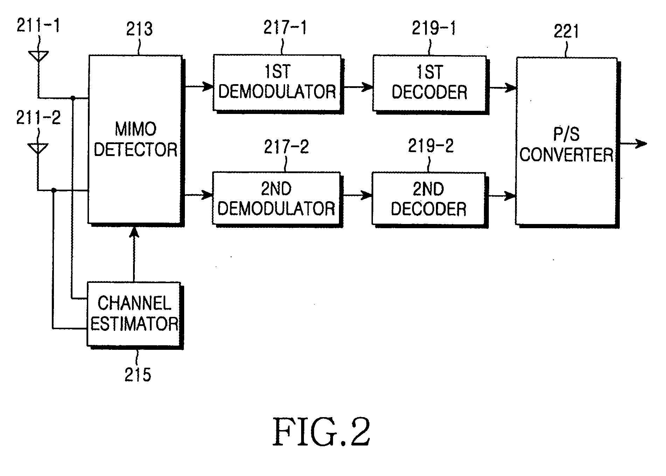

FIG. 2 illustrates a structure of a signal reception apparatus in a conventional LDPC-PARC MIMO communication system. The signal reception apparatus shown in FIG. 2 uses two reception antennas Rx.ANT, by way of example.

Referring to FIG. 2, the signal reception apparatus includes a first reception antenna 211-1, a second reception antenna 211-2, a MIMO detector 213, a channel estimator 215, a first (1^{ST}) demodulator 217-1, a second (2^{ND}) demodulator 217-2, a first (1^{ST}) decoder 219-1, a second (2^{ND}) decoder 219-2, and a Parallel-to-Serial (P/S) converter 221.

Signals received through the first and second reception antennas 211-1 and 211-2 are output to the MIMO detector 213 and the channel estimator 215.

The channel estimator 215 estimates channel responses using the signals received through the first and second reception antennas 211-1 and 211-2, in particular, pilot signals which are reference signals. The channel estimator 215 outputs the estimated channel responses to the MIMO detector 213.
The MIMO detector 213 detects the signals received through the first and second reception antennas 211-1 and 211-2 depending on the channel responses output from the channel estimator 215 using a preset detection scheme, thereby generating a first reception symbol and a second reception symbol. The MIMO detector 213 outputs the first reception symbol to the first demodulator 217-1 and the second reception symbol to the second demodulator 217-2.

Herein, the detection scheme can be any one of, for example, Maximum Likelihood (ML), Minimum Mean Square Error (MMSE) and Zero Forcing (ZF).

The first demodulator 217-1 demodulates the first reception symbol into a first demodulation symbol using a demodulation scheme associated with the modulation scheme used in the modulator of the signal transmission apparatus associated with the signal reception apparatus, for example, the first modulator 115-1. The first demodulator 217-1 outputs the first demodulation symbol to the first decoder 219-1.

The second demodulator 217-2 demodulates the second reception symbol into a second demodulation symbol using a demodulation scheme associated with the modulation scheme used in the modulator of the signal transmission apparatus, for example, the second modulator 115-2, and outputs the second demodulation symbol to the second decoder 219-2.

The first decoder 219-1 decodes the first demodulation symbol into a first decoded symbol using a decoding scheme, i.e. LDPC decoding scheme, associated with the coding scheme used in the encoder of the signal transmission apparatus, for example, the first encoder 113-1, and outputs the first decoded symbol to the P/S converter 221.

The second decoder 219-2 decodes the second demodulation symbol into a second decoded symbol using a decoding scheme, i.e. LDPC decoding scheme, associated with the coding scheme used in the encoder of the signal transmission apparatus, for example, the second encoder 113-2, and outputs the second decoded symbol to the P/S converter 221.

The P/S converter 221 serial-converts the first decoded symbol and the second decoded symbol into the original information data stream.
Although not separately illustrated in FIG. 2, the signal reception apparatus includes a transmitter for transmitting the transmission antenna CQIs to the signal transmission apparatus. An operation of generating and transmitting the transmission antenna CQIs by the signal reception apparatus is well known in the art, so a detailed description thereof will be omitted herein.

As described above, in the LDPC-PARC MIMO communication system, the signal transmission apparatus can recognize channel status of the signal reception apparatus. Therefore, there is a need for a scheme for efficiently transmitting/receiving LDPC-coded signals obtained by performing LDPC coding considering the channel status of the signal reception apparatus.

### SUMMARY OF THE INVENTION

An aspect of the present invention is to address at least the problems and/or disadvantages and to provide at least the advantages described below. Accordingly, an aspect of the present invention is to provide an apparatus and method for transmitting/receiving signals in a Multiple Input Multiple Output (MIMO) communication system.

Another aspect of the present invention is to provide an apparatus and method for transmitting/receiving Low Density Parity Check (LDPC)-coded signals considering channel status in an (Low Density Parity Check-Per Antenna Rate Control) LDPC-PARC MIMO communication system.

According to one aspect of the present invention, there is provided an apparatus for transmitting a signal in a MIMO communication system. The apparatus includes an encoder for encoding an input information data stream into a codeword using a preset coding scheme, a MIMO mapper for mapping the codeword using a preset MIMO mapping scheme thereby generating at least one mapped symbol, modulators for modulating the mapped symbols into modulation symbols according to a modulation scheme, a transmitter for performing transmission processing on the modulation symbols thereby generating transmission streams, and transmitting the transmission streams via transmission antennas, and a controller for detecting each transmission antenna channel status depending on CQI received from a signal reception apparatus associated with the signal transmission apparatus, determining an antenna to be used by the signal transmission apparatus depending on the detected transmission antenna channel status, and transmitting the transmission streams via the determined antenna.

According to another aspect of the present invention, there is provided an apparatus for receiving a signal in a MIMO communication system. The apparatus includes a channel estimator for estimating a channel response through signals received via at least one reception antenna, a MIMO detector for detecting the received signals using a preset detection scheme thereby generating reception symbols, demodulators for demodulating the reception symbols into demodulation symbols, a MIMO demapper for demapping the demodulation symbols into a codeword using a MIMO demapping scheme, a decoder for decoding the codeword into an original information bit stream according to a decoding scheme, and a controller for performing a control operation so as to demodulate the reception symbols generated by detecting the received signals based on the channel response, according to a demodulation scheme associated with a modulation scheme of a transmission apparatus that transmitted the received signals, and demaps the demodulated symbols according to a MIMO demapping scheme associated with a MIMO mapping scheme of the transmission apparatus.

According to a further aspect of the present invention, there is provided a method for transmitting a signal in a MIMO communication system. The method includes determining transmission antennas to be used by a signal transmission apparatus depending on CQI received from a reception apparatus, encoding an input information data stream into a codeword using a preset coding scheme, mapping the codeword using a preset MIMO mapping scheme thereby generating at least one mapped symbol, modulating the mapped symbols into modulation symbols according to a modulation scheme, and performing transmission processing on the modulation symbols thereby generating transmission streams, and transmitting the transmission streams via the determined transmission antennas.

According to another aspect of the present invention, there is provided a method for receiving a signal in a MIMO communication system. The method includes estimating a channel response through signals received via at least one reception antenna, detecting the received signals based on the channel response using a preset MIMO detection scheme thereby generating reception symbols, demodulating the reception symbols into demodulation symbols, demapping the demodulation symbols into a codeword using a MIMO demapping scheme, and decoding the codeword into an original information bit stream according to a preset decoding scheme.

### BRIEF DESCRIPTION OF THE DRAWINGS

The above and other objects, features and advantages of the present invention will become more apparent from the following detailed description when taken in conjunction with the accompanying drawings in which:
FIG. 1 illustrates a structure of a signal transmission apparatus in a conventional LDPC-PARC MIMO communication system;
FIG. 2 illustrates a structure of a signal reception apparatus in a conventional LDPC-PARC MIMO communication system;
FIG. 3 illustrates a structure of a signal transmission apparatus in an LDPC-PARC MIMO communication system according to the present invention;
FIG. 4 illustrates a parity check matrix of an LDPC code with a coding rate 1/3;
FIG. 5 illustrates an operation of a signal transmission apparatus in an LDPC-PARC MIMO communication system according to the present invention;
FIG. 6 illustrates a structure of a signal reception apparatus in an LDPC-PARC MIMO communication system according to the present invention; and
FIG. 7 illustrates an operation of a signal reception apparatus in an LDPC-PARC MIMO communication system according to the present invention.

### DETAILED DESCRIPTION OF THE PREFERRED EMBODIMENTS

Preferred embodiments of the present invention will now be described in detail with reference to the annexed drawings. In the following description, a detailed description of known functions and configurations incorporated herein has been omitted for the sake of clarity and conciseness.

The present invention provides an apparatus and method for transmitting/receiving signals in a communication system using, for example, an (Low Density Parity Check-Per Antenna Rate Control) LDPC-PARC Multiple Input Multiple Output (MIMO) communication system.

For the sake of convenience, the present invention will be described with reference to the PARC MIMO scheme, by way of example. However, the present invention is not limited to the PARC MIMO scheme, and can be applied to the systems that transmit different channel statuses for individual transmission streams, such as Per Common Basis Rate Control (PCBRA) and Per Unitary Basis stream User and Rate Control (PU²RC).

Generally, for an Low Density Parity Check (LDPC) code, bits included in its LDPC codeword can constitute a codeword bit set according to a degree of each of the codeword bits and their codeword bit connection relationship. The codeword bit set can be simple in terms of its decoding even for a poor channel status. On the contrary, the codeword bit set can be difficult in terms of its decoding even for a good channel status.

By considering such LDPC code characteristics, it is possible to transmit, for example, high-degree codeword bits through a good-channel status channel and low-degree codeword bits through a poor-channel status channel, thereby improving decoding performance of the LDPC codeword. Herein, the channel status can be determined depending on information indicating channel status, for example, Channel Quality Information (CQI). The CQI is generated depending on CINR, based on which it can be determined whether the channel status is good or poor.

The present invention provides a scheme for determining a codeword bit set of codeword bits transmitted through each transmission antenna Tx.ANT not only based on the degree of the LDPC code but also based on the number of codeword bits transmitted through a poor-channel status channel, thereby improving decoding performance of the LDPC code.

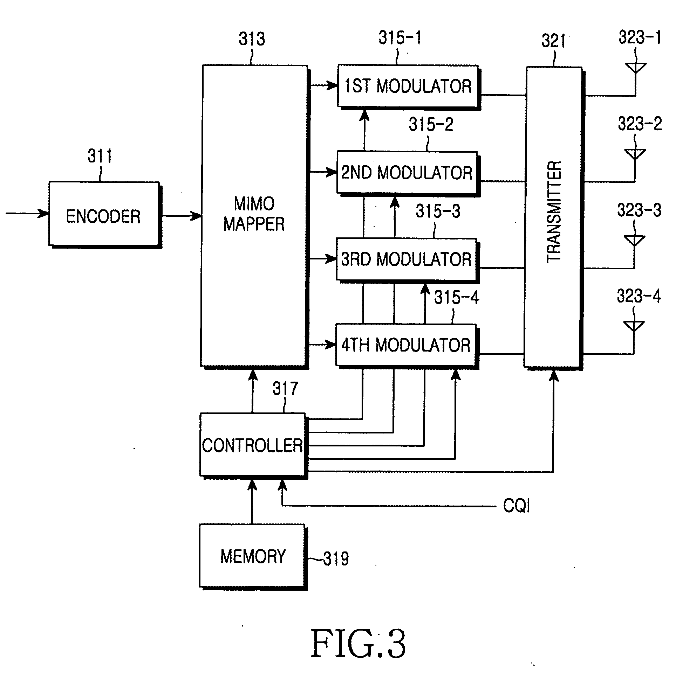

FIG. 3 illustrates a structure of a signal transmission apparatus in an LDPC-PARC MIMO communication system according to the present invention. The signal transmission apparatus shown in FIG. 3 uses four transmission antennas, by way of example.

Referring to FIG. 3, the signal transmission apparatus includes an encoder 311, a MIMO mapper 313, a first (1^{ST}) modulator 315-1, a second 92^{ND}) modulator 315-2, a third (3^{RD}) modulator 315-3, a fourth (4^{TH}) modulator 315-4, a controller 317, a memory 319, a transmitter 321, a first transmission antenna 323-1, a second transmission antenna 323-2, a third transmission antenna 323-3 and a fourth transmission antenna 323-4.

If information data bits, i.e. information data stream, are received, the encoder 311 encodes the information data stream into a codeword, i.e. LDPC codeword, using a coding scheme. The encoder 311 outputs the generated LDPC codeword to the MIMO mapper 313. Herein, the coding scheme is an LDPC coding scheme.

The MIMO mapper 313, under the control of the controller 317, maps the LDPC codeword output from the encoder 311 using a preset MIMO mapping scheme, thereby generating at least one mapped symbol. The MIMO mapper 313 outputs the generated mapped symbol to a corresponding modulator.

The controller 317 determines use/non-use of the first, second, third and fourth transmission antennas 323-1, 323-2, 323-3 and 323-4 according to each transmission antenna CQI received from a signal reception apparatus associated with the signal transmission apparatus.

The term "transmission antenna CQI" as used herein refers to CQI indicating channel status of the channel that the signal transmitted via each transmission antenna experiences, referred to hereinafter as "transmission antenna channel status."

The controller 317 allows the transmitter 321 to use all or some of the first, second, third and fourth transmission antennas 323-1, 323-2, 323-3 and 323-4 according to the transmission antenna CQIs.

The controller 317 detects each transmission antenna channel status using the transmission antenna CQIs. If there is a transmission antenna having a channel status in which the signal reception apparatus cannot normally receive signals, among the detected transmission antenna channel statuses, the controller 317 controls the transmitter 321 such that no signal is transmitted via the corresponding transmission antenna.
In this manner, the controller 317 determines a transmission antenna(s) to be used by the transmitter 321, and controls generation of a transmission stream according to the determined transmission antenna. The term "transmission stream" as used herein refers to a signal finally transmitted via the transmission antenna in the signal transmission apparatus.

For example, if the transmitter 321 determines to use three transmission antennas, for example, the first, second and third transmission antennas 323-1, 323-2 and 323-3 among the transmission antennas 323-1 to 323-4, the controller 317 controls the MIMO mapper 313 such that it generates three mapped symbols, i.e. a first mapped symbol, a second mapped symbol and a third mapped symbol, using the LDPC codeword.
Then the MIMO mapper 313 outputs the first mapped symbol to the first modulator 315-1, the second mapped symbol to the second modulator 315-2 and the third mapped symbol to the third modulator 315-3.

In addition, the controller 317 controls the MIMO mapper 313 such that it generates at least one mapped symbol with the LDPC codeword according to a codeword bit set decision rule. Herein, the codeword bit set decision rule is stored in the memory 319, and the controller 317 controls the MIMO mapper 313 such that it generates at least one mapped symbol with the LDPC codeword according to the codeword bit set decision rule. A description of the codeword bit set decision rule will be made hereinbelow.

Each of the first modulator 315-1, the second modulator 315-2, the third modulator 315-3 and the fourth modulator 315-4 modulates the mapped symbol output from the MIMO mapper 313 into a modulation symbol according to a modulation scheme, and outputs the modulation symbol to the transmitter 321. The modulation schemes used in the first, second, third and fourth modulators 315-1, 315-2, 315-3 and 315-4 can be different from each other. For the sake of convenience, it will be assumed herein that all four modulators use the modulation scheme.

As previously stated, any one ofBinary Phase Shift Keying (BPSK) scheme, Quadrature Phase Shift Keying (QPSK) scheme, Quadrature Amplitude Modulation (QAM) scheme, Pulse Amplitude Modulation (PAM) scheme, and Phase Shift Keying (PSK) scheme, can be used as the modulation scheme.

Use/non-use of the first, second, third and fourth modulators 315-1, 315-2, 315-3 and 315-4 is determined according to the transmission antennas determined by the controller 317, as described above.

The transmitter 321, under the control of the controller 317, performs transmission processing on the modulation symbols of the first, second, third and fourth modulators 315-1, 315-2, 315-3 and 315-4, thereby generating transmission streams, and then transmits the transmission streams via at least one of the first, second, third and fourth transmission antennas 323-1, 323-2, 323-3 and 323-4.

In addition, use/non-use of the first, second, third and fourth transmission antennas 323-1, 323-2, 323-3 and 323-4 is determined according to the transmission antennas determined by the controller 317, as described above.

A description will now be made of the codeword bit set decision rule.

Assuming that the number of codeword bits included in the LDPC codeword is N and the number of mapped symbols used in the LDPC-PARC MIMO communication system is Ns, the number Np of codeword bits necessary for each of the Ns mapped symbols is Np=N/Ns. Therefore, Ns codeword bit sets including Np codeword bits as their elements can be defined. If the Ns codeword bit sets are defined as S1, S2, ···, SNs, the elements included in each of the codeword bit sets S1, S2, ···, SNs are determined according to the codeword bit set decision rule.

Herein, the codeword bit set decision rule is for generating mapped symbols with codeword bits being robust against puncturing among the codeword bits included in the LDPC codeword such that they can be transmitted via a transmission antenna having a low reliability, i.e. having a poor channel status.

Therefore, the controller 317 controls a MIMO mapping operation of the MIMO mapper 313 such that Ns codeword bit sets S 1, S2, ···, SNs of the LDPC codeword are transmitted via the highest-reliability transmission antenna, i.e. the best-channel status transmission antenna, starting from a first codeword bit set S1.

Herein, the controller 317 can determine whether the channel status is good or bad depending on the CQI received from the signal reception apparatus, and the higher CQI-based CINR generally indicates the better channel status. In this manner, the controller 317 controls the MIMO mapping operation of the MIMO mapper 313 such that the Ns codeword bit sets S1, S2, ···, SNs are transmitted via their associated transmission antennas. As a result, among the Ns codeword bit sets S1, S2, ···, SNs, the last codeword bit set SNs is transmitted via the worst-channel status transmission antenna.

Therefore, the controller 317 controls the codeword bits of the LDPC codeword, being robust against puncturing, such that they are included in the codeword bit set SNs and the codeword bit set SNs is transmitted to the signal reception apparatus via the worst-channel status transmission antenna. The codeword bits being robust against puncturing differ according to a parity check matrix of the LDPC code. Generally, the high-degree codeword bits are robust against puncturing, but an increase in the number of punctured high-degree codeword bits makes it difficult to decode the LDPC code. Therefore, the codeword bits constituting each codeword bit set differ according to Np. That is, the controller 317 stores the codeword bit sets generated depending on Ns and Np in the memory 319, and determines corresponding codeword bit sets among the codeword bit sets stored in the memory 319 according to the CQI received from the signal reception apparatus. In addition, the controller 317 outputs information on the determined codeword bit sets to the MIMO mapper 313 so that the MIMO mapper 313 generates mapped symbols with the LDPC codeword and outputs them to Ns modulators.

Although not separately illustrated in FIG. 3, the signal transmission apparatus includes a receiver for receiving the transmission antenna CQIs transmitted by the signal reception apparatus. An operation of receiving the transmission antenna CQIs by the signal transmission apparatus is well known in the art, so a detailed description thereof will be omitted herein.

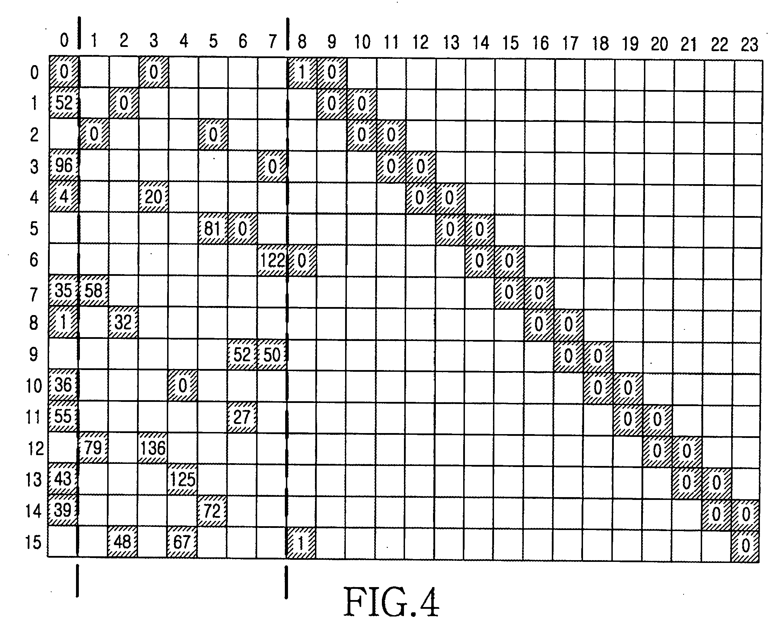

FIG. 4 illustrates a parity check matrix of an LDPC code with a coding rate 1/3.

As illustrated in FIG. 4, the entire parity check matrix of the LDPC code is divided into a plurality of blocks, to each of which a permutation matrix is mapped. Herein, the permutation matrix is assumed to have a size zxz.

Referring to FIG. 4, the parity check matrix of the LDPC code is divided into 16x24 blocks, to each of which a zxz permutation matrix is mapped. A numeral shown in each block of FIG. 4 indicates a value by which an identity matrix is shifted. A zero matrix is mapped to every block in which no numeral is shown. Because the parity check matrix of the LDPC code is divided into 16x24 blocks as described above, the number of column blocks is 24 and the number of row blocks is 16. Indexes of the 24 column blocks are defined as C0, C1, ···, C23, and indexes of the 16 row blocks are defined as R0, R1, ···, R15.

A description will now be made of an operation performed when the signal transmission apparatus transmits an LDPC codeword using the parity check matrix shown in FIG. 4.
In a first example in which the signal transmission apparatus uses two transmission antennas, the MIMO mapper 313 generates two mapped symbols, i.e. a first mapped symbol and a second mapped symbol. The first mapped symbol is transmitted via the best channel status transmission antenna among the two transmission antennas, and the second mapped symbol is transmitted via the other transmission antenna. Therefore, the first mapped symbol should include a codeword bit set S1={C0, C1, C2, C3, C4, C5, C6, C7, C8, C12, C16, C20}, and the second mapped symbol should include a codeword bit set S2={C9, C10, C11, C13, C14, C15, C17, C18, C19, C21, C22, C23}. That is, the second mapped symbol should include lower-degree parity bits. Because the number Np of the codeword bits transmitted via the worst-channel status channel is 1/2 of the total number of codeword bits constituting the LDPC codeword, the LDPC codeword may suffer degradation of its decoding performance when high-degree bits are included in the codeword bit set S2.

In a second example in which a signal transmission apparatus uses three transmission antennas, the MIMO mapper 313 generates three mapped symbols, i.e. a first mapped symbol, a second mapped symbol and a third mapped symbol. The first mapped symbol is transmitted via the best-channel status transmission antenna among the three transmission antennas, the second mapped symbol is transmitted via the next best-channel status transmission antenna, and the third mapped symbol is transmitted via the remaining transmission antenna. Therefore, the first mapped symbol should include a codeword bit set S1={C8, C 10, C12, C14, C16, C18, C20, C22}, the second mapped symbol should include a codeword bit set S2={C9, C11, C13, C15, C17, C19, C21, C23}, and the third mapped symbol should include a codeword bit set S3={C0, C1, C2, C3, C4, C5, C6, C7}. The number Np of the codeword bits transmitted via the worst-channel status channel is 1/3 of the total number of codeword bits constituting the LDPC codeword, and decoding performance of the LDPC codeword is improved when high-degree codeword bits are included in the codeword bit set S3.

In a third example in which the signal transmission apparatus uses all of the four transmission antennas, the MIMO mapper 313 generates four mapped symbols, i.e. a first mapped symbol, a second mapped symbol, a third mapped symbol and a fourth mapped symbol. The first mapped symbol is transmitted via the best-channel status transmission antenna, the second mapped symbol is transmitted via the next best-channel status transmission antenna, the third mapped symbol is transmitted via the next best-channel status transmission antenna, and the fourth mapped symbol is transmitted via the remaining transmission antenna. Therefore, the first mapped symbol should include a codeword bit set S1= {C9, C11, C14, C17, C19, C22 }, the second mapped symbol should include a codeword bit set S2 = {C10, C13, C15, C18, C21, C23}, the third mapped symbol should include a codeword bit set S3 ={C5, C6, C8, C12, C16, C20}, and the fourth mapped symbol should include a codeword bit set S4 = {C0, C1, C2, C3, C4, C7}. The number Np of the codeword bits transmitted via the worst-channel status channel is 1/4 of the total number of codeword bits constituting the LDPC codeword, and decoding performance of the LDPC codeword is improved when high-degree codeword bits are included in the codeword bit set S4.

In the codeword bit set decision rule, the controller 317 determines the codeword bits to be generated as a mapped symbol transmitted via the worst-channel status transmission antenna, considering the following. Herein, for the sake of convenience, the mapped symbol transmitted via the worst-channel status transmission antenna will be referred to as a "decoding performance improved mapped symbol."

First, although it is preferable to generate the decoding performance improved mapped symbol with the high-degree codeword bits of the parity check matrix of the LDPC codeword, an increase in the number of the high-degree codeword bits included in the decoding performance improved mapped symbol may degrade decoding performance of the LDPC code. Therefore, the controller 317 determines the number of high-degree codeword bits to be included in the decoding performance improved mapped symbol according to Np and Ns.

Second, the controller 317 preferentially selects the codeword bits that a permutation matrix of other codeword bits is not included in one parity check equation, compared with other codeword bits among the high-degree codeword bits, and includes the selected codeword bits in the decoding performance improved mapped symbol. That is, it can be noted that in the parity check matrix shown in FIG. 4, a permutation matrix 122 of a 7^{th} codeword bit among the 0^{th} to 7^{th} high-degree codeword bits never overlaps with the permutation matrix where a 6^{th} parity check equation among the 0^{th} to 15^{th} parity check equations is included in the other 0^{th} to 6^{th} codeword bits. Therefore, the controller 317 determines the 7^{th} codeword bit as a codeword bit to be first included in the decoding performance improved mapped symbol.

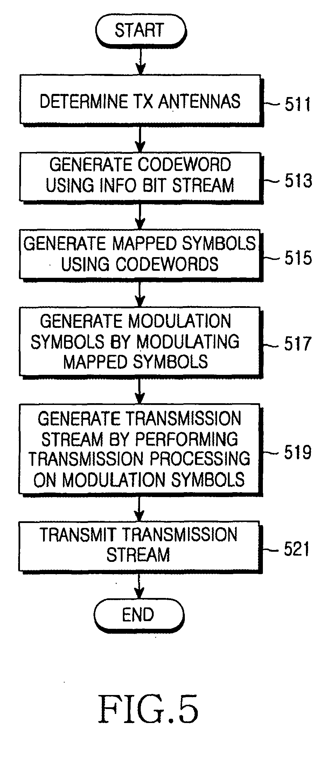

FIG. 5 illustrates an operation of a signal transmission apparatus in an LDPC-PARC MIMO communication system according to the present invention.

Referring to FIG. 5, in step 511, the signal transmission apparatus determines transmission (TX) antennas to be used therein according to transmission antenna CQIs received from a signal reception apparatus. In step 513, the signal transmission apparatus encodes an input information bit stream into an LDPC codeword using an LDPC coding scheme. In step 515, the signal transmission apparatus generates as many mapped symbols as the number of the determined transmission antennas using the LDPC codeword. Herein, an operation of generating the mapped symbols with the LDPC codeword is performed according to the codeword bit set decision rule. In step 517, the signal transmission apparatus modulates the generated mapped symbols into modulation symbols using a preset modulation scheme. In step 519, the signal transmission apparatus performs transmission processing on the modulation symbols, thereby generating transmission streams. In step 521, the signal transmission apparatus transmits the transmission streams via the determined transmission antennas, and then ends the operation.

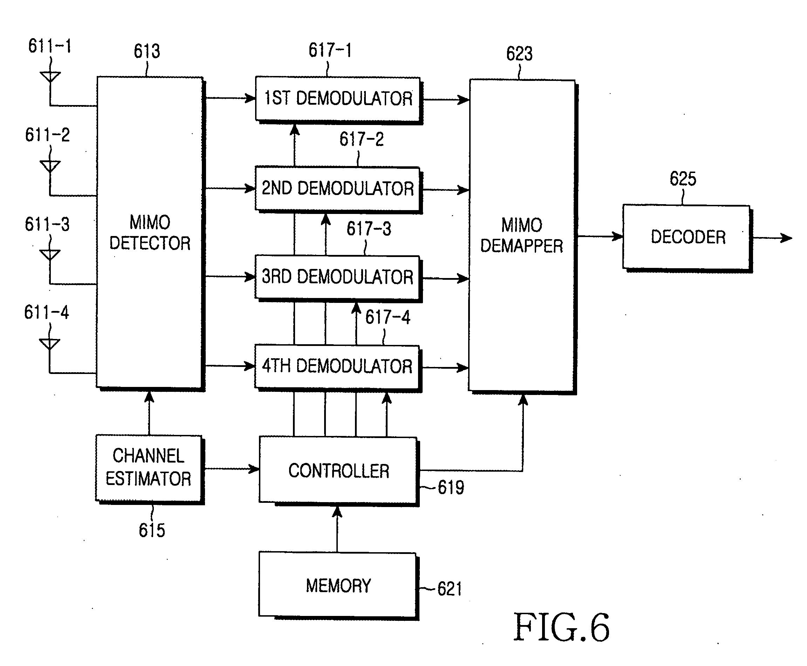

FIG. 6 illustrates a structure of a signal reception apparatus in an LDPC-PARC MIMO communication system according to the present invention. The signal reception apparatus shown in FIG. 6 uses four reception antennas Rx.ANT, by way of example.

Referring to FIG. 6, the signal reception apparatus includes a first reception antenna 611-1, a second reception antenna 611-2, a third reception antenna 611-3, a fourth reception antenna 611-4, a MIMO detector 613, a channel estimator 615, a first (1^{ST}) demodulator 617-1, a second (2^{ND}) demodulator 617-2, a third (3^{RD}) demodulator 617-3, a fourth (4^{TH}) demodulator 617-4, a controller 619, a memory 621, a MIMO demapper 623 and a decoder 625.

Signals received through the first reception antenna 611-1 to the fourth reception antenna 611-4 are delivered to the MIMO detector 613 and the channel estimator 615. The channel estimator 615 estimates channel responses using the signals received through the first reception antenna 611-1 to the fourth reception antenna 611-4, in particular, pilot signals which are reference signals. The channel estimator 615 outputs the estimated channel responses to the MIMO detector 613.

The MIMO detector 613 detects the signals received through the first reception antenna 611-1 to the fourth reception antenna 611-4 depending on the channel responses output from the channel estimator 615 using a detection scheme, thereby generating a first reception symbol to a fourth reception symbol. The MIMO detector 613 outputs the first reception symbol to the first demodulator 617-1, the second reception symbol to the second demodulator 617-2, the third reception symbol to the third demodulator 617-3 and the fourth reception symbol to the fourth demodulator 617-4.

Herein, the detection scheme can be any one of, for example, Maximum Likelihood (ML), Minimum Mean Square Error (MMSE) and Zero Forcing (ZF).

The first demodulator 617-1, under the control of the controller 619, demodulates the first reception symbol into a first demodulation symbol using a demodulation scheme associated with the modulation scheme used in the modulator of the signal transmission apparatus associated with the signal reception apparatus, for example, the first modulator 315-1. The first demodulator 617-1 outputs the first demodulation symbol to the MIMO demapper 623.

The second demodulator 617-2, under the control of the controller 619, demodulates the second reception symbol into a second demodulation symbol using a demodulation scheme associated with the modulation scheme used in the modulator of the signal transmission apparatus associated with the signal reception apparatus, for example, the second modulator 315-2. The second demodulator 617-2 outputs the second demodulation symbol to the MIMO demapper 623.

The third demodulator 617-3, under the control of the controller 619, demodulates the third reception symbol into a third demodulation symbol using a demodulation scheme associated with the modulation scheme used in the modulator of the signal transmission apparatus associated with the signal reception apparatus, for example, the third modulator 315-3. The third demodulator 617-3 outputs the third demodulation symbol to the MIMO demapper 623.

The fourth demodulator 617-4, under the control of the controller 619, demodulates the fourth reception symbol into a fourth demodulation symbol using a demodulation scheme associated with the modulation scheme used in the modulator of the signal transmission apparatus associated with the signal reception apparatus, for example, the fourth modulator 315-4. The fourth demodulator 617-4 outputs the fourth demodulation symbol to the MIMO demapper 623.

The controller 619 controls operations of the demodulators according to operations of the modulators controlled by the controller 317 of the signal transmission apparatus.

The MIMO demapper 623, under the control of the controller 619, demaps the first demodulation symbol to the fourth demodulation symbol into an LDPC codeword using a MIMO demapping scheme associated with the MIMO mapping scheme of the MIMO mapper 313 of the signal transmission apparatus, and then outputs the LDPC codeword to the decoder 625. Herein, the controller 619 demaps the first demodulation symbol to the fourth demodulation symbol into an LDPC codeword according to a codeword bit set decision rule stored in the memory 621. The codeword bit set decision rule has been described above. The decoder 625 decodes the LDPC codeword output from the MIMO demapper 623 into the original information bit stream using a decoding scheme, i.e. LDPC decoding scheme.

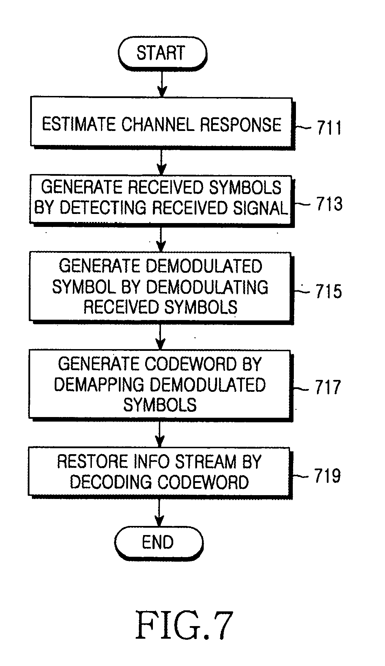

FIG. 7 illustrates an operation of a signal reception apparatus in an LDPC-PARC MIMO communication system according to the present invention.

Referring to FIG. 7, in step 711, the signal reception apparatus estimates channel responses by performing channel estimation on the signals received through reception antennas. In step 713, the signal reception apparatus detects the received signals based on the channel responses using a detection scheme, thereby generating reception symbols. In step 715, the signal reception apparatus demodulates the reception symbols into demodulation symbols using a demodulation scheme associated with the modulation scheme used in the signal transmission apparatus. In step 717, the signal reception apparatus MIMO-demaps the demodulation symbols into an LDPC codeword. In step 719, the signal reception apparatus decodes the LDPC codeword into the original information bit stream using a decoding scheme, i.e. LDPC decoding scheme.

As described above, for each of the streams that will experience different fading, the MIMO communication system allocates the bits being robust against puncturing to the stream experiencing the worst channel, thereby obtaining channel gain, and has no need for adjusting a coding rate separately for each stream as it uses a single encoder, thereby obtaining diversity and coding gains.

As can be understood from the foregoing description, the disclosed LDPC-PARC MIMO communication system can transmit/receive signals according to channel status. In other words, for each of the streams experiencing different fading, the system allocates the bits being robust against puncturing to the worst-channel status channel, thereby obtaining channel gain. In addition, the system does not need to adjust a coding rate separately for each stream as it uses a single encoder, thereby obtaining diversity effect and coding gain.

While the invention has been shown and described with reference to a certain preferred embodiment thereof, it will be understood by those skilled in the art that various changes in form and details may be made therein without departing from the spirit and scope of the invention as defined by the appended claims.

## Claims

1. An apparatus for transmitting a signal in a Multiple Input Multiple Output (MIMO) communication system, the apparatus comprising:
an encoder for encoding an input information data stream into a codeword using a coding scheme;
a MIMO mapper for mapping the codeword using a MIMO mapping scheme thereby generating at least one mapped symbol;
modulators for modulating the mapped symbols into modulation symbols according to a modulation scheme;
a transmitter for performing transmission processing on the modulation symbols thereby generating transmission streams, and transmitting the transmission streams via transmission antennas; and
a controller for detecting a channel status of each transmission antenna depending on channel quality information received from a signal reception apparatus associated with the signal transmission apparatus, determining an antenna to be used by the signal transmission apparatus depending on the detected transmission antenna channel status, and transmitting the transmission streams via the determined antenna.

2. The apparatus of claim 1, wherein the channel quality information received from the signal reception apparatus indicates a channel status of a channel that a signal transmitted via each transmission antenna.

3. The apparatus of claim 1, wherein the controller does not transmit a signal via a corresponding transmission antenna when the transmission antenna channel status indicates a status in which the signal reception apparatus cannot normally receive signals.

4. The apparatus of claim 1, wherein the encoder uses a Low Density Parity Check (LDPC) coding scheme.

5. The apparatus of claim 1, wherein the controller controls generation of mapped symbols such that codeword bits being robust against puncturing among codeword bits included in the codeword are transmitted via poor-channel status transmission antennas.

6. The apparatus of claim 1, further comprising a memory for storing codeword bit sets generated according to a number of the mapped symbols and the number of codeword bits necessary for each of the mapped symbols.

7. The apparatus of claim 6, wherein the controller determines a corresponding codeword bit set among the codeword bit sets stored in the memory according to the channel quality information, and outputs information on the codeword bit set to the MIMO mapper so that the MIMO mapper generates a mapped symbol with the codeword depending on the output information.

8. An apparatus for receiving a signal in a (MIMO) communication system, the apparatus comprising:
a channel estimator for estimating a channel response through signals received via at least one reception antenna;
a MIMO detector for detecting the received signals using a detection scheme thereby generating reception symbols;
demodulators for demodulating the reception symbols into demodulation symbols;
a MIMO demapper for demapping the demodulation symbols into a codeword using a MIMO demapping scheme;
a decoder for decoding the codeword into an original information bit stream according to a decoding scheme; and
a controller for performing a control operation so as to demodulate the reception symbols generated by detecting the received signals based on the channel response, according to a demodulation scheme associated with a modulation scheme of a transmission apparatus that transmitted the received signals, and demaps the demodulated symbols according to a MIMO demapping scheme associated with a MIMO mapping scheme of the transmission apparatus.

9. The apparatus of claim 8, wherein the channel estimator estimates a channel through pilot signals which are reference signals.

10. The apparatus of claim 8, wherein the MIMO detector uses at least one of Maximum Likelihood (ML), Minimum Mean Square Error (MMSE), and Zero Forcing (ZF) detection schemes.

11. The apparatus of claim 8, wherein the decoder uses a Low Density Parity Check (LDPC) decoding scheme.

12. A method for transmitting a signal in a Multiple Input Multiple Output (MIMO) communication system, the method comprising:
determining transmission antennas to be used by a signal transmission apparatus depending on channel quality information received from a reception apparatus;
encoding an input information data stream into a codeword using a coding scheme;
mapping the codeword using a MIMO mapping scheme thereby generating at least one mapped symbol;
modulating the mapped symbols into modulation symbols according to a modulation scheme; and
performing transmission processing on the modulation symbols thereby generating transmission streams, and transmitting the transmission streams via the determined transmission antennas.

13. The method of claim 12, wherein the channel quality information indicates a channel status of a channel that a signal transmitted via each transmission antenna.

14. The method of claim 12, wherein the coding scheme includes a Low Density Parity Check (LDPC) coding scheme.

15. The method of claim 12, wherein a number of the generated mapped symbols is equal to a number of the determined transmission antennas.

16. The method of claim 12, further comprising generating the mapped symbols such that codeword bits being robust against puncturing among codeword bits included in the codeword are transmitted via poor-channel status transmission antennas.

17. A method for receiving a signal in a (MIMO) communication system, the method comprising:
estimating a channel response through signals received via at least one reception antenna;
detecting the received signals based on the channel response using a MIMO detection scheme thereby generating reception symbols;
demodulating the reception symbols into demodulation symbols;
demapping the demodulation symbols into a codeword using a MIMO demapping scheme; and
decoding the codeword into an original information bit stream according to a decoding scheme.

18. The method of claim 17, wherein the channel response estimation further comprises estimating a channel through pilot signals which are reference signals.

19. The method of claim 17, wherein the MIMO detection scheme includes at least one of Maximum Likelihood (ML), Minimum Mean Square Error (MMSE), and Zero Forcing (ZF) detection schemes.

20. The method of claim 17, wherein the decoding scheme includes a Low Density Parity Check (LDPC) decoding scheme.
